# EUROPEAN PATENT APPLICATION

(11) **EP 4 521 474 A1**
(43) Date of publication of application: **12.03.2025**
(21) Application number: 24157508.3
(22) Date of filing: 14.02.2024
(51) Int. Cl.: H01L 31/18, H01L 31/0745

(54) **SOLAR CELL AND METHOD FOR PRODUCING A SOLAR CELL**

(30) Priority: 05.09.2023 CN 202311138411
(71) Applicant: Trina Solar Co., Ltd, Changzhou, Jiangsu 213031 (CN)
(72) Inventor: LIU, Chengfa, Changzhou, 213031 (CN); CHEN, Hong, Changzhou, 213031 (CN)
(74) Representative: Nederlandsch Octrooibureau

(57) **Abstract**

The present disclosure provides a solar cell and a method for producing a solar cell. The solar cell comprises, a silicon substrate (110) including a first surface and a second surface opposite to each other; a first doped layer (120) disposed on the first surface; a second doped layer (130) disposed on the second surface, a doped type of the first doped layer is opposite to a doped type of the second doped layer; a first electrode (140) connecting to the first doped layer (120); a second electrode (150) connecting to the second doped layer (130); and an isolation trench (160) penetrating the first doped layer (120) along a thickness direction of the silicon substrate and surrounding the first electrode (140). The solar cell of the present disclosure uses an isolation trench (160) penetrating the first doped layer (120) to isolate the electrode from the edge of the solar cell, thereby avoiding leakage of the solar cell due to short circuit.

## Description

### Technical Field

The present disclosure mainly relates to the technical fields of photovoltaic technology, and specifically relates to a solar cell and a method for producing a solar cell.

### Background

Among the many technologies that utilize solar energy, solar cells have attracted much attention due to their ability to convert solar energy into electrical energy. Solar cells generate electron-hole pairs when exposed to light, and the electron-hole pairs separate inside the cell and move toward the two poles of the cell respectively. With the deepening of research, the types of solar cells have gradually become richer. At present, solar cell types mainly include passivated emitter and rear contact (PERC), tunnel oxide passivated contact (TOPCON), hetero-junction with intrinsic thin film (HIT) and interdigitated back contact (IBC) battery technology, etc. During the producing process of solar cells, due to factors such as the manufacturing process and production environment, short-circuit current may occur when the solar cell is working, for example, short-circuit current is caused by undesired contact between electrodes and some functional layers in the solar cell. Short-circuit current will decrease the efficiency of the solar cell, and short-circuit current inside the solar cell should be avoided.

### Summary

The technical problem to be solved by the present disclosure is to provide a solar cell and a method for producing a solar cell, the solar cell and the method for producing a solar cell can prevent solar cells from leakage due to short circuits.

To solve the above technical problems, the present disclosure provides a solar cell, comprising a silicon substrate including a first surface and a second surface opposite to each other; a first doped layer disposed on the first surface; a second doped layer disposed on the second surface, a doped type of the first doped layer is opposite to a doped type of the second doped layer; a first electrode connecting to the first doped layer; a second electrode connecting to the second doped layer; and an isolation trench penetrating the first doped layer along a thickness direction of the silicon substrate and surrounding the first electrode.

In one embodiment, a distance between the isolation trench and an edge of the first doped layer is less than a preset distance, wherein the preset distance is 10µm~2000µm.

In one embodiment, the solar cell further comprising a tunneling layer, the tunneling layer is disposed on the second surface, and the second doped layer is disposed on a surface of the tunneling layer away from the silicon substrate.

In one embodiment, the tunneling layer extends to a side of the silicon substrate and covers at least part of the side of the silicon substrate, and the second doped layer covers the surface of the tunneling layer away from the silicon substrate, wherein a height of the tunneling layer on the side of the silicon substrate is equal to or greater than 0.1 µm, and is equal to or less than a thickness of the silicon substrate.

In one embodiment, the solar cell further comprising a first passivation layer, the first passivation layer is disposed on a surface of the first doped layer that away from the silicon substrate.

In one embodiment, the first passivation layer covers a bottom and a side of the isolation trench.

In one embodiment, the solar cell further comprising a second passivation layer, the second passivation layer is disposed on a surface of the second doped layer away from the silicon substrate.

The present disclosure also provides a method for producing a solar cell, comprising, providing a silicon substrate, wherein the silicon substrate includes a first surface and a second surface opposite to each other; forming a first doped layer on the first surface of the silicon substrate; successively forming a tunneling layer and a second doped layer on the second surface of the silicon substrate, wherein a doped type of the first doped layer is opposite to a doped type of the second doped layer; forming a first electrode connected to the first doped layer; forming a second electrode connected to the second doped layer; and forming an isolation trench penetrating the first doped layer along a thickness direction of the silicon substrate and surrounding the first electrode.

In one embodiment , the method of forming the tunneling layer and the second doped layer comprises: forming an initial tunneling layer on the second surface, the side of the silicon substrate, and at least part of a surface of the first doped layer away from the silicon substrate; forming an initial second doped layer on a surface of the initial tunneling layer away from the silicon substrate; removing the initial tunneling layer and the initial second doped layer on the first doped layer to form the tunneling layer and the second doped layer.

In one embodiment, after forming the initial tunneling layer and the initial second doped layer, and before removing the initial tunneling layer and the initial second doped layer on the first doped layer, forming the isolation trench.

In one embodiment, the method for producing a solar cell removing part of the initial tunneling layer and the initial second doped layer on the side of the silicon substrate, a height of the tunneling layer, and the second doped layer on the side of the silicon substrate is equal to or greater than 0.1 µm, and equal to or less than a thickness of the silicon substrate.

In one embodiment, a distance between the isolation trench and an edge of the first doped layer is less than a preset distance, wherein the preset distance is 10µm~2000µm.

In one embodiment, the method for producing a solar cell forming a first passivation layer on a surface of the first doped layer away from the silicon substrate.

In one embodiment, the first passivation layer is formed after forming the isolation trench.

In one embodiment, the method for producing a solar cell forming a second passivation layer on a surface of the second doped layer away from the silicon substrate.

In one embodiment, the isolation trench is formed after forming the second passivation layer.

The solar cell and the method for producing a solar cell of the present disclosure use an isolation trench penetrating the first doped layer to isolate the electrode from the edge of the solar cell, thereby avoiding leakage of the solar cell due to a short circuit.

### Description of the Drawings

In order to make the above purposes, features and advantages of the present disclosure more obvious and understandable, the specific implementation modes of the present disclosure are described in detail below with reference to the accompanying drawings, wherein:
Fig. 1 is a schematic top view of a solar cell according to an embodiment of the present disclosure;
Fig.2 is a schematic cross-sectional view of the solar cell in Fig. 1 along line A-A according to an embodiment of the present disclosure;
Fig.3 is a schematic cross-sectional view of the solar cell in Fig. 1 along line A-A of another embodiment of the present disclosure;
Fig.4 is an exemplary flow chart of a method for producing a solar cell according to an embodiment of the present disclosure;
Fig.5 to Fig. 13 are schematic cross-sectional views of intermediate products in the solar cell production process in one embodiment;
Fig.14 and Fig.15 are exemplary flow charts for forming isolation trench in various embodiments.

Signs of the drawings, silicon substrate 110, first surface 111, second surface 112, side 113, first doped layer 120, internal doped layer 121, peripheral doped layer 122, edge 123, surface 124, first edge 123a, second edge 123b, third edge 123c, fourth edge 123d, initial first doped layer 120a, second doped layer 130, main body part 131, extension part 132, surface 133, initial second doped layer 130a, first electrode 140 , the first grid line 141, the second grid line 142, the second electrode 150, the isolation trench 160, the first isolation trench 160a, the second isolation trench 160b, the third isolation trench 160c, the fourth isolation trench 160d, and the edge of the solar cell 170, tunneling layer 180, main body part 181, extension part 182, initial tunneling layer 180a, first passivation layer 190, and second passivation layer 210.

### Detailed Description

In order to make the above objects, features and advantages of the present disclosure more obvious and understandable, the specific embodiments of the present disclosure are described in detail below with reference to the accompanying drawings.

Many specific details are set forth in the following description to fully understand the present disclosure, but the present disclosure can also be implemented in other ways different from those described here, so the present disclosure is not limited by the specific embodiments disclosed below.

As shown in this application and claims, words such as "a", "an", "an" and/or "the" do not specifically refer to the singular and may include the plural unless the context clearly indicates an exception. Generally speaking, the terms "comprising" and "comprising" only imply the inclusion of clearly identified steps and elements, and these steps and elements do not constitute an exclusive list. The method or apparatus may also include other steps or elements.

When describing the embodiments of the present disclosure in detail, for convenience of explanation, the cross-sectional views showing the device structure are not partially enlarged according to the general scale, and the schematic diagrams are only examples, which should not limit the scope of protection of the present disclosure. In addition, the three-dimensional dimensions of length, width and depth should be included in actual production.

For convenience of description, spatial relationship words such as "below", "below", "below", "below", "above", "on", etc. may be used to describe an element shown in the drawings. or the relationship of a feature to other elements or features. It will be understood that these spatially relative terms are intended to encompass other orientations of the device in use or operation in addition to the orientations depicted in the Figs For example, if the device in the Figs is turned over, elements described as "below" or "under" or "under" other elements or features would then be oriented "above" the other elements or features. Thus, the exemplary words "below" and "below" can encompass both upper and lower directions. The device may be otherwise oriented (rotated 90 degrees or at other orientations) and the spatially relative descriptors used herein should be interpreted accordingly. Additionally, it will also be understood that when a layer is referred to as being "between" two layers, it can be the only layer between the two layers, or one or more intervening layers may also be present.

In the context of this application, structures described as having a first feature "on" a second feature may include embodiments in which the first and second features are formed in direct contact, and may also include embodiments in which additional features are formed between the first and second features. Embodiments between second features such that the first and second features may not be in direct contact.

In addition, it should be noted that the use of words such as "first" and "second" to define parts is only to facilitate the distinction between corresponding parts. Unless otherwise stated, the above words have no special meaning and therefore cannot be understood. To limit the scope of protection of this application.

The flow chart is used in this application to illustrate the operations performed by the system according to the embodiment of this application. It should be understood that the preceding or following operations are not necessarily performed in an exact order. Instead, various steps may be processed in reverse order or concurrently. And, other operations can either add to these procedures, or a certain step or steps can be removed from these procedures.

A solar cell and a method for producing solar cell of the present disclosure will be described through specific embodiments.

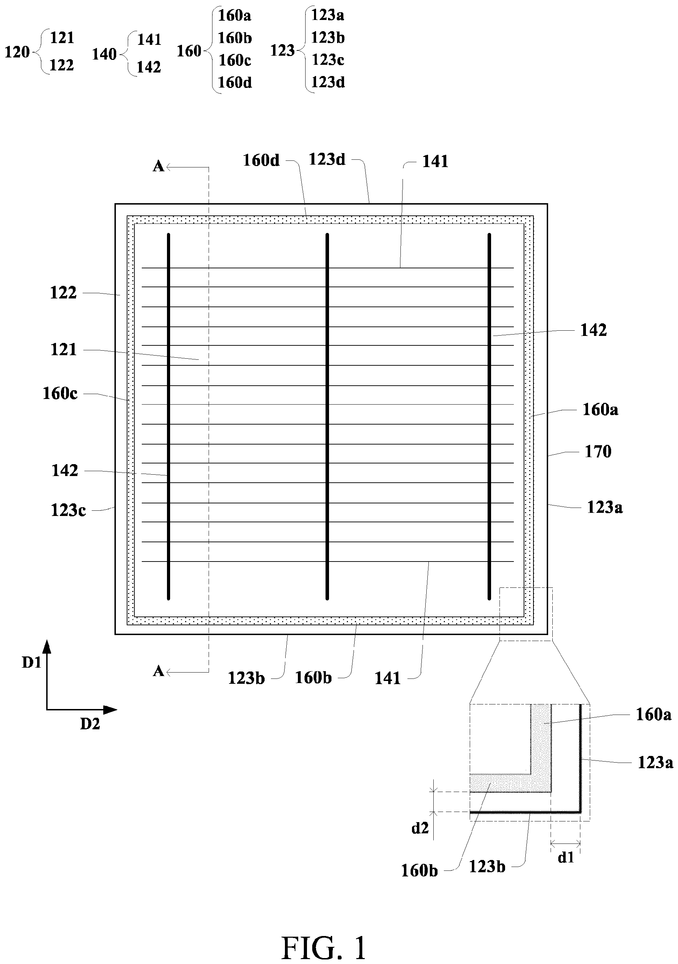

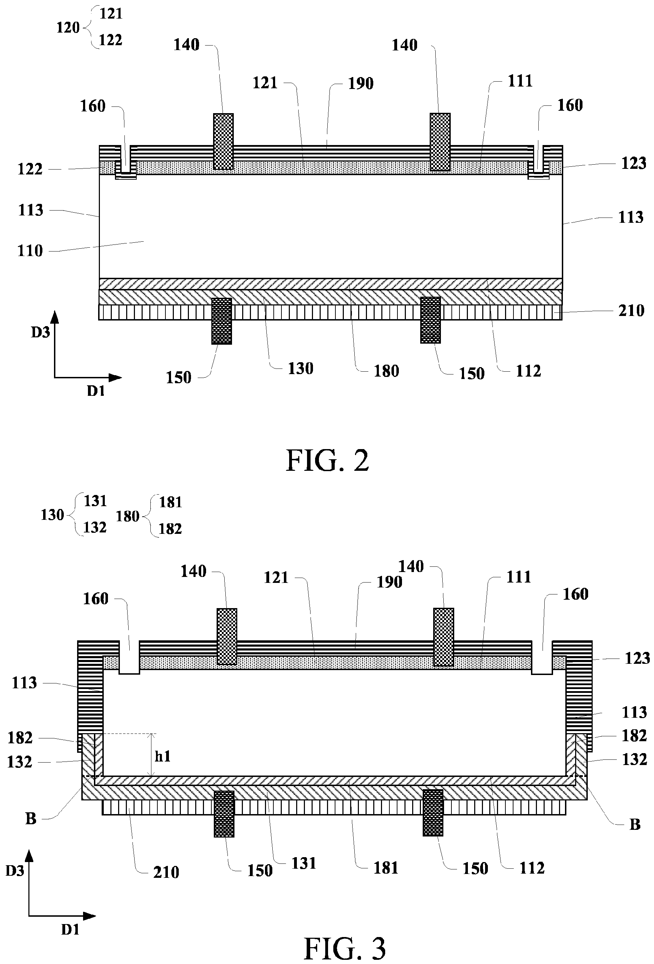

Fig.1 is a schematic top view of a solar cell according to an embodiment. Fig. 2 is a schematic cross-sectional view of the solar cell in Fig.1 along line A-A of an embodiment. Fig. 2 omits part of the first electrode to simplify the Fig. Referring to Fig. 1 and Fig. 2, the solar cell comprises a silicon substrate 110, a first doped layer 120, a second doped layer 130, a first electrode 140, a second electrode 150 and an isolation trench 160.

As shown in Fig.2, the silicon substrate 110 has a first surface 111 and a second surface 112 opposite to each other along a thickness direction D3 of the silicon substrate 110, and two sides 113 that are opposite along a first direction D1. It can be understood that the silicon substrate 110 also has two opposite sides in a second direction D2. The first surface 111 and the second surface 112 may have a pyramid texture, which helps reduce reflection of incident light by the solar cell.

The silicon substrate 110 may be a doped monocrystalline silicon wafer or a doped polycrystalline silicon wafer, and the doped type may be N-type doped or P-type doped. When the silicon substrate 110 is N-type doped, the dopant may be selected from one or more of phosphorus (P), bismuth (Bi), antimony (Sb) or arsenic (As); when the silicon substrate 110 is P-type doped, the dopant may be selected from one or more types of boron (B), aluminum (Al), gallium (Ga) or indium (In).

The first doped layer 120 is disposed on the first surface 111. "Disposed on" includes two situations: the first doped layer 120 is in direct contact with the first surface 111, and other functional layers are provided between the first doped layer 120 and the first surface 111. This instruction also applies to the following paragraphs, and the instruction will not be further expanded in the following paragraphs. In Fig. 2, the first doped layer 120 is in direct contact with the first surface 111. The method of forming the first doped layer 120 comprises performing a doped process on the silicon substrate 110 so that a part of the silicon substrate 110 is transformed into the first doped layer 120. In addition to the above method, the first doped layer 120 may also be deposited on the first surface 111 through a deposition process. The first doped layer 120 may be doped monocrystalline silicon or doped polysilicon.

The second doped layer 130 is disposed on the second surface 112. The second doped layer 130 may be doped polysilicon. When the second doped layer 130 is doped polysilicon, the method of forming the second doped layer 130 comprises, depositing a layer of amorphous silicon on the second surface 112, and doping the amorphous silicon, performing heat treatment on the doped amorphous silicon to convert the amorphous silicon into polysilicon.

The doped type of the second doped layer 130 is opposite to that of the first doped layer 120, and the doped type of one of the doped layers is the same as that of the silicon substrate 110. For example, there are the following situations,

The silicon substrate 110 is N-type doped, the first doped layer 120 is P-type doped, the second doped layer 130 is N-type doped, and the first doped layer 120 and the silicon substrate 110 form a PN junction;

The silicon substrate 110 is N-type doped, the first doped layer 120 is N-type doped, the second doped layer 130 is P-type doped, and the second doped layer 130 and the silicon substrate 110 form a PN junction;

The silicon substrate 110 is P-type doped, the first doped layer 120 is N-type doped, the second doped layer 130 is P-type doped, and the first doped layer 120 and the silicon substrate 110 form a PN junction;

The silicon substrate 110 is P-type doped, the first doped layer 120 is P-type doped, the second doped layer 130 is N-type doped, and the second doped layer 130 and the silicon substrate 110 form a PN junction.

In the above situation, the doped concentration of the first doped layer 120 may be greater than the doped concentration of the silicon substrate 110, and the doped concentration of the second doped layer 130 can also be greater than the doped concentration of the silicon substrate 110.

For convenience of description, the solar cell described below will take the N-type doped silicon substrate 110, the P-type doped first doped layer 120, and the N-type doped second doped layer 130 as an example. Wherein, the doped concentration of the second doped layer 130 is greater than the doped concentration of the silicon substrate 110.

Referring to Fig. 2, the first electrode 140 is in contact with the first doped layer 120, and the second electrode 150 is in contact with the second doped layer 130. The first electrode 140 and the second electrode 150 may be used to export electrical energy generated by the solar cell. As shown in Fig.1, the first electrode 140 includes a plurality of first grid lines 141 and a plurality of second grid lines 142. The plurality of first grid lines 141 are arranged at intervals along the first direction D1, and the plurality of second grid lines 142 are arranged at intervals along the second direction D2. Each second grid line 142 is connected to a plurality of the first grid line 141. The first grid line 141 can be used to collect the current generated by the solar cell, and the second grid line 142 can be used to gather the current collected by the plurality of second grid line 141. The second electrode 150 may also have an electrode structure like the first grid line 141 and the second grid line 142 in the first electrode 140, which will not be further described.

Referring to Fig. 2, the isolation trench 160 penetrates the first doped layer 120 in the thickness direction D3. As shown in Fig.1, from a top view of the solar cell, the isolation trench 160 is a closed rectangle, and the closed rectangle surrounds all the first electrodes 140. As shown in Fig.1 and Fig.2, the first doped layer 120 is divided into two parts by the isolation trench 160, one part is surrounded by the isolation trench 160, and the other part is not surrounded by the isolation trench 160 which is located between an edge 170 of the solar cell and the isolation trench 160. For convenience of description, the part of the first doped layer 120 surrounded by the isolation trench 160 is labeled as the internal doped layer 121, and the part of the first doped layer not surrounded by the isolation trench 160 is labeled as the peripheral doped layer 122. The internal doped layer 121 is in contact with the first electrode 140, and carriers (for example, holes or electrons) in the internal doped layer 121 can be transported to the outside of the solar cell through the first electrode 140. Due to the division of the isolation trench 160, the internal doped layer 121 is not in contact with the peripheral doped layer 122. Therefore, there is no electrical connection between the internal doped layer 121 and the peripheral doped layer 122 (there is no electrical connection between the peripheral doped layer 122 and the first electrode). If there is a connection between the peripheral doped layer 122 and the second doped layer 130, the internal doped layer 121 and the second doped layer 130 will not be connected due to the isolation effect of the isolation trench 160, thereby preventing the solar cell from leaking due to short circuit.

The shape of the isolation trench 160 is not limited to the rectangular shape shown in Fig.1. The isolation trench 160 may also be in other shapes surrounding the first electrode 140, such as a circle, an ellipse, or other polygonal shapes.

Referring to Fig.1 and Fig.2, in one embodiment, the first doped layer 120 has an edge 123, and the edge 123 refers to the outermost side of the first doped layer 123 in the first direction D1. The edge 123 is a rectangle surrounding the isolation trench 160. The distance between the isolation trench 160 and the edge 123 is less than the preset distance, the preset distance is any value from 10µm~2000µm, for example, 10µm, 50µm, 100µm, 200µm, 300µm, 400µm, 500µm, 1000µm, 1500µm or 2000µm. Specifically, as shown in Fig. 1, the edge 123 can be divided into four parts, a first edge 123a on the right, a second edge 123b on the bottom, a third edge 123c on the left, and a fourth edge 123d on the top, the isolation trench 160 can also be divided into four parts: the first isolation trench 160a on the right, the second isolation trench 160b on the bottom, the third isolation trench 160c on the left and the fourth isolation trench 160d on the top. Referring to the partial enlarged schematic view in Fig. 1, the distance between the first isolation trench 160a and the first edge 123a is distance d1 in the second direction D2, and the distance between the second isolation trench 160b and the second edge 123b is distance d2 in the first direction D1. Similarly, the third isolation trench 160c and the third edge 123c are separated by a distance d3 in the second direction D2, and the fourth isolation trench 160d and the fourth edge 123d are separated by a distance d4 in the first direction D1 (distance d3 and distance d4 are not shown in the figure). The distances d1, d2, d3, and d4 are all smaller than the preset distance, and the distances d1, d2, d3, and d4 may be the same or different.

Referring to Fig. 1 and Fig.2, the first doped layer 120 and the silicon substrate 110 form a PN junction. When the solar cell is operating, the carriers in the internal doped layer 121 can be output through the first electrode 140 connected thereto, due to the isolation effect of the isolation trench 160, the carriers in the peripheral doped layer 122 cannot be output through the first electrode 140. Generally speaking, when the solar cell is operating, the internal doped layer 121 participates in the output of electric energy, and the peripheral doped layer 122 does not participate in the output of electric energy. To increase the electric energy generated by the solar cell, the area of the internal doped layer 121 should be increased as much as possible. Limiting the distance between the isolation trench 160 and the edge of the first doped layer 120 being smaller than the preset distance helps to increase the area of the internal doped layer 121.

In Fig. 1, the isolation trench 160 and the edge 123 are both rectangular, and the isolation trench 160 can be divided into multiple segments. For example, the second isolation trench 160b and the fourth isolation trench 160d are divided into multiple segments along the first direction D1, the first isolation trench 160a, and the third isolation trench 160c are divided into multiple segments along the second direction D2. In this case, the minimum distance between each segment and the edge 123 is less than the preset distance. In this way, the area of the internal doped layer 121 can be made as large as possible. In other words, the distance between the isolation trench 160 and the edge 123 should be set as much as possible to maximize the area of the internal doped layer 121, which helps maximize the power generated by the solar cell.

Referring to Fig. 2, the cross-section of the isolation trench 160 is U-shaped. In some other embodiments, the cross-section of the isolation trench 160 may also be V-shaped. The present discourse does not limit the depth and width of the isolation trench 160, but the depth and width should meet the requirements for electrical isolation of the internal doped layer 121 and the peripheral doped layer 122. The depth can be any value from 2µm ~ 50µm, and the width can be any value from 5µm ~ 60µm.

Referring to Fig.2, in one embodiment, the solar cell further comprises a tunneling layer 180. The tunneling layer 180 is disposed on the second surface 112, and the second doped layer 130 is disposed on a surface of the tunneling layer 180 that is away from the silicon substrate 110 in the thickness direction D3. The tunneling layer 180 has a tunneling effect. The tunneling layer 180 allows majority carriers (such as electrons) to pass through and blocks minority carriers (such as holes) from passing through, which helps to reduce carrier recombination. In one embodiment, the tunneling layer 180 is a layer of silicon oxide (SiOₓ), a layer of doped polysilicon can be formed on one surface of the silicon oxide layer that away from the silicon substrate 110 as the second doped layer 130, the silicon oxide layer and the doped polysilicon layer together form the passivation structure. Even if the minority carriers pass through the silicon oxide layer, they will be blocked by the internal electric field generated by the doped concentration difference between the doped polysilicon layer and the silicon substrate, and it is difficult to reach the interface between the second electrode and the doped polysilicon layer, thus avoiding the recombination of the majority carriers and minority carriers at the interface.

Fig. 3 is a schematic cross-sectional view of the solar cell in Fig.1 along line A-A in another embodiment. One difference between Fig.3 and Fig.2 is that the tunneling layer 180 in Fig.3 extends to the side 113 of the silicon substrate 110 and covers part of the side 113, that is, the tunneling layer 180 is formed on the second surface 112, and part of the side 113, and the tunneling layer located on the second surface 112 and the tunneling layer located on the side 113 are continuous. For convenience of description, in Fig.3, the tunnel layer located on the second surface 112 is marked as the main body part 181, and the tunneling layer located on the side 113 is marked as the extension part 182. To facilitate understanding of the specific meanings of the main body part 181 and the extension part 182, a dotted line B is used in Fig. 3 to represent the boundary between them.

Another difference between Fig. 3 and Fig. 2 is that the second doped layer 130 extends from the main body part 181 to the extension part 182, and the second doped layer 130 covers the surface of the main body part 181 that away from the silicon substrate 110 in the thickness direction D3 and the surface of the extension part 182 that away from the silicon substrate 110 in the first direction D1. For convenience of description, the second doped layer located on the main body part 181 is marked as the main body part 131, and the second doped layer located on the extension part 182 is marked as the extension part 132. To facilitate understanding of the specific meanings of the main body part 131 and the extension part 132, a dotted line B is used in Fig. 3 to represent the boundary between them.

Referring to Fig. 3, the extension part 182 and the extension part 132 have the same or substantially the same height. The height h1 of both is equal to or greater than 0.1µm, and equal to or less than the thickness of the silicon substrate. Wherein, the height h1 refers to the size in the thickness direction D3. In Fig. 3, extension part 182 and extension part 132 are formed on part of the side 113. In some other embodiments, the extension part 182 and the extension part 132 can also be formed on the entire side 113, in which case the height h1 is equal to the thickness of the silicon substrate. On the one hand, extending the tunneling layer 180 and the second doped layer 130 to the side 113 can increase the carrier collection area, on the other hand, it can increase the passivation contact area between the passivation structure and the silicon substrate 110 and reducing carrier recombination at the edge of the solar cell.

Referring to Fig.1 and Fig. 2, the solar cell further comprises a first passivation layer 190. The first passivation layer 190 is disposed on the surface of the first doped layer 120 which is away from the silicon substrate 110 in the thickness direction D3. In Fig. 2, the first passivation layer 190 covers the bottom and the sides of the isolation trench 160. In Fig. 3, the first passivation layer 190 does not cover the bottom and the sides of the isolation trench 160. The reason for the above difference is that the process step of forming the first passivation layer 190 in Fig. 2 is after the process step of forming the isolation trench 160, and the process step of forming the first passivation layer 190 in Fig. 3 is before the process step of forming the isolation trench 160.

The first passivation layer 190 has a passivation effect on the solar cell, which helps to reduce carrier recombination and improves the efficiency of the solar cell. The first passivation layer 190 can be a field passivation layer with field effect passivation or a chemical passivation layer with chemical passivation, it can also be a stacked passivation structure composed of a field passivation layer-chemical passivation layer. In some embodiments, the solar cell further comprises a first anti-reflective layer, which is disposed on a surface of the first passivation layer 190 facing away from the silicon substrate 110. The first anti-reflection layer can reduce the reflection of incident light by the solar cell and improve the utilization rate of incident light.

Referring to Fig.3, the first passivation layer 190 extends to the side 113 of the silicon substrate 110 and is in contact with the extension part 132 and the extension part 182, part of the surface (or the entire surface) of the extension part 132 away from the silicon substrate 110 in the first direction D1 is covered by the first passivation layer 190.

Referring to Fig. 2, in one embodiment, the solar cell further comprises a second passivation layer 210. The second passivation layer 210 is disposed on the surface of the second doped layer 130 which is away from the silicon substrate 110. The second passivation layer 210 has a passivation effect on the solar cell, helping to reduce carrier recombination and improving the efficiency of the solar cell. The second passivation layer 210 may be a field passivation layer with the effect of field effect passivation or may be a chemical passivation layer with chemical passivation, it can also be a stacked passivation structure composed of a field passivation layer-chemical passivation layer. In some embodiments, the solar cell further comprises a second anti-reflective layer disposed on a surface of the second passivation layer 210 that is away from the silicon substrate 110. The second anti-reflection layer can reduce the reflection of incident light by the solar cell and improve the utilization rate of incident light.

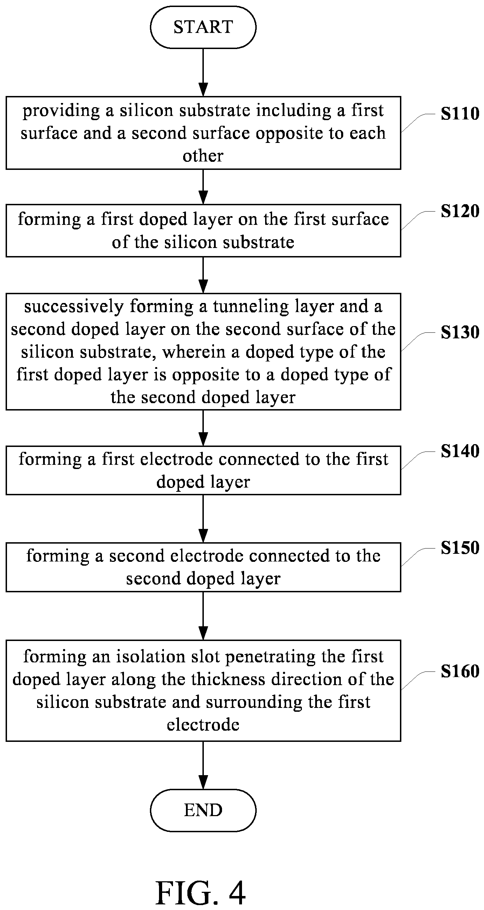

The present disclosure also proposes a method for producing a solar cell. Fig.4 is an exemplary flow chart of a method for producing a solar cell according to an embodiment. Referring to Fig.4, the producing method of this embodiment comprises the following steps,
Step S110: providing a silicon substrate including a first surface and a second surface opposite to each other;
Step S120: forming a first doped layer on the first surface of the silicon substrate;
Step S130: successively forming a tunneling layer and a second doped layer on the second surface of the silicon substrate, and a doped type of the first doped layer is opposite to a doped type of the second doped layer;
Step S140: forming a first electrode connected to the first doped layer;
Step S150: forming a second electrode connected to the second doped layer;
Step S160: forming an isolation trench penetrating the first doped layer along the thickness direction of the silicon substrate and surrounding the first electrode.

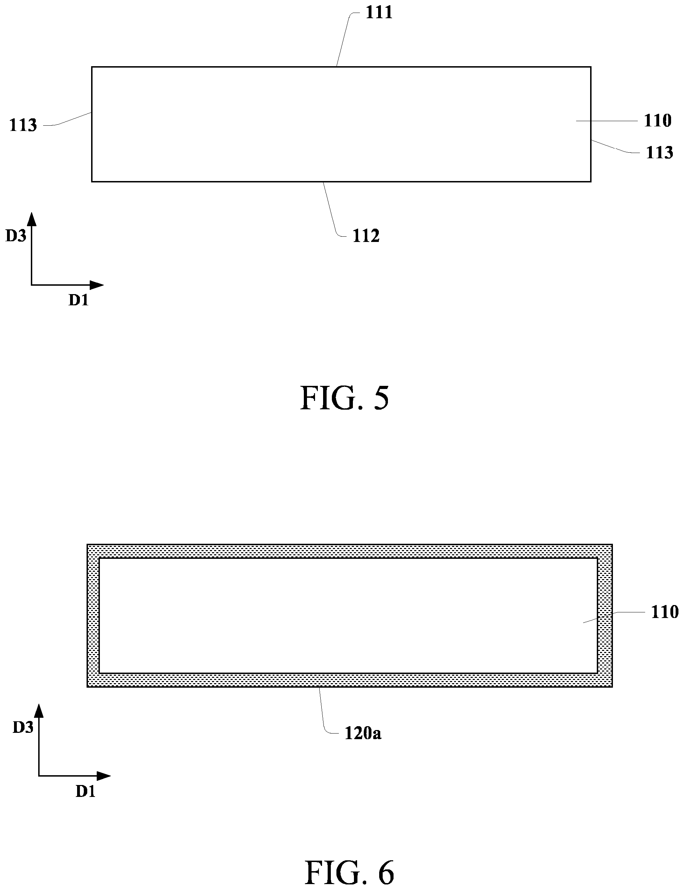

Fig.5 to Fig.13 are schematic cross-sectional views of intermediate products of the solar cell producing process in one embodiment. The above steps S110 to S160 will be described in detail below with reference to Fig.5 to Fig.13.

Referring to Fig.5, in step S110, a silicon substrate 110 is provided, the silicon substrate 110 has a first surface 111 and a second surface 112 opposite to each other in the thickness direction D3. The silicon substrate 110 may be a doped monocrystalline silicon wafer or a doped polycrystalline silicon wafer, and the doped type may be N-type doped or P-type doped. The following description takes the silicon substrate 110 of N-type doped monocrystalline silicon as an example.

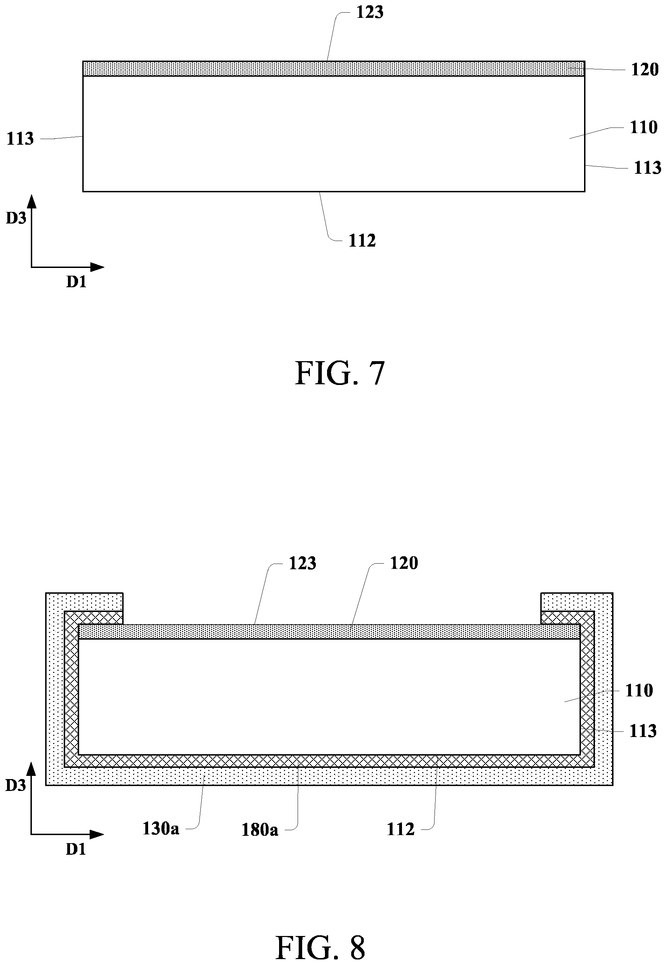

Referring to Fig.5 and Fig.7, in step S120, a first doped layer 120 is formed on the first surface 111. The first doped layer 120 may be P-type doped monocrystalline silicon, N-type doped monocrystalline silicon, P-type doped polysilicon, or N-type doped polysilicon. The following description will take P-type doped monocrystalline silicon as an example. The first doped layer 120 of P-type doped monocrystalline silicon and the silicon substrate 110 of N-type doped monocrystalline silicon form a PN junction.

In one embodiment, a method of forming the first doped layer 120 comprises, performing a doped process on the silicon substrate 110 and then retaining the doped layer on the first surface 113. For example, as shown in Fig.5, Fig. 6, and Fig.7, the silicon substrate 110 is subjected to a boron-diffused process, and the boron diffuses into the silicon substrate 110 to a certain depth to form an initial first doped layer 120a. The initial first doped layer 120a is also formed on other surfaces of the silicon substrate 110 except the first surface 111, the initial first doped layer 120a on surfaces other than the first surface 111 is removed to form the first doped layer 120. The initial first doped layer 120a on surfaces other than the first surface 111 may be removed by wet etching.

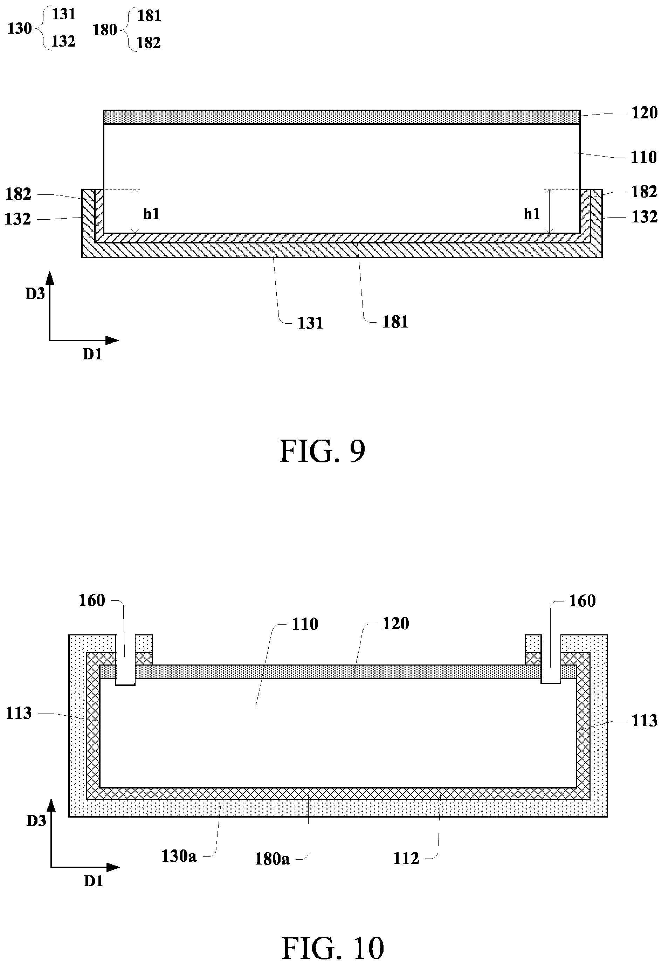

Referring to Fig. 5 and Fig. 9, in step S130, the tunneling layer 180 and the second doped layer 130 are successively formed on the second surface 112. The doped type of the second doped layer 130 is opposite to the doped type of the first doped layer 120. The following description will take the second doped layer 130 in N-type doped as an example. The doped concentration of the second doped layer 130 may be greater than that of the silicon substrate 110.

In some embodiments, a method of forming the tunneling layer 180 and the second doped layer 130 comprises,
Step S131: forming an initial tunneling layer on the second surface, the side of the silicon substrate, and at least part of the surface of the first doped layer that away from the silicon substrate;
Step S132: forming an initial second doped layer on the surface of the initial tunneling layer away from the silicon substrate;
Step S133: removing the initial tunneling layer and the initial second doped layer on the first doped layer to form the tunneling layer and the second doped layer.

The specific description of step S131 to step S133 is as follows.

Referring to Fig.7 and Fig. 8, surface 123 of the first doped layer 120 is away from the silicon substrate 110 in the thickness direction D3. Step S131 forms an initial tunneling layer 180a on the second surface 112, the side 113, and part of the surface 123. Due to the process of forming the initial tunneling layer 180a, the initial tunneling layer 180a also covers other areas except from the second surface 112. Specifically, the process of forming the initial tunneling layer 180a can choose atomic layer deposition (ALD), chemical vapor deposition (CVD) or physical vapor deposition (PVD), etc. When forming the initial tunneling layer 180a using the above process, ideally the initial tunneling layer 180a should be formed in the target area, the second surface 112 or the second surface 112, and at least part of the side 113. However, due to the process itself, the initial tunneling layer 180a will also be deposited in other non-target areas (such as the surface 123).

Referring to FIG.7, an initial tunneling layer 180a is formed on the second surface 112, the side 113, and the part of the surface 123. In step S132, an initial second doped layer 130a is formed on the initial tunneling layer 180a. Ideally, the initial second doped layer 130a should be formed on the initial tunneling layer located on the second surface 112, and the side 113, should not be formed on the initial tunneling layer located on the surface 123.

Referring to Fig. 7 and Fig. 9, in step S133, the initial tunneling layer and the initial second doped layer on the first doped layer 120 are removed, and part of the initial tunneling layer on the side 113 and part of the initial second doped layer on the side 113 are also removed to form the tunneling layer 180 and second doped layer 130 shown in Fig. 9. Referring to Fig. 8, Fig.9, and Fig.3, the upper part of the initial tunneling layer and the upper part of the initial second doped layer located on the side 113 are removed, and the extension part 182 and the extension part 132 are retained, so that the height h1 of the extension part 182 and the extension part 132 located on the side 113 is equal to or greater than 0.1µm and less than the thickness of the silicon substrate 110. In other embodiments, the initial tunneling layer and the initial second doped layer on the first doped layer 120 are removed, but the initial tunneling layer and the initial second doped layer on the side 113 are not removed. In this case, the height h1 of the extension part 182 and the extension part 132 is equal to the thickness of the silicon substrate 110. The method of removing the initial tunneling layer and the initial second doped layer includes a wet etching process.

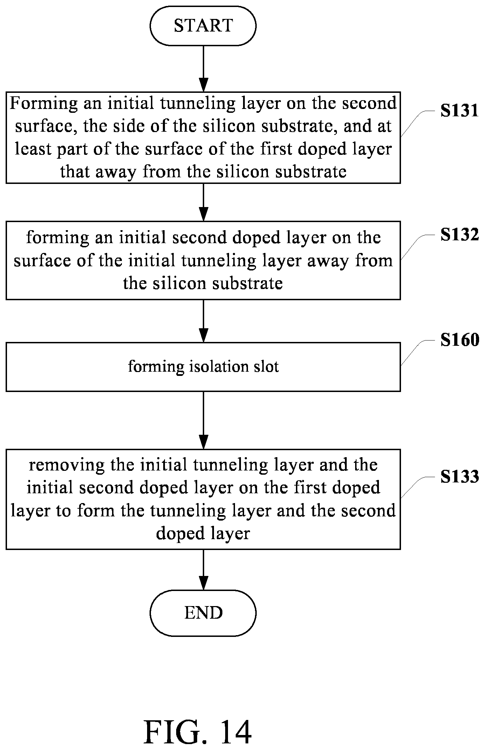

Referring to Fig. 10 and the flow chart shown in Fig. 14, in one embodiment, after the formation of the initial tunneling layer 180a and the initial second doped layer 130a (ie, step S132), and before the removal of the initial tunneling layer and the initial second doped layer on the first doped layer 120 (step S133), forming the isolation trench 160 (step S160), and step S133 is performed after the formation of the isolation trench 160. Fig. 10 shows the isolation trench 160 formed using the steps in Fig. 14, the isolation trench 160 penetrates the initial tunneling layer 180a, the initial second doped layer 130a, and the first doped layer 120.

The method of forming the isolation trench 160 comprises laser-etching the initial tunneling layer 180a, the initial second doped layer 130a, and the first doped layer 120, and forms the isolation trench 160 penetrating through the initial tunneling layer 180a, the initial second doping layer 130a, and the first doped layer 120. In the process of using a laser to form the isolation trench 160, the laser may cause damage to the silicon substrate 110, the initial tunneling layer 180a, the initial second doped layer 130a, and the first doped layer 120 in the isolation trench 160 exposed by the isolation trench 160. Setting the step of forming the isolation trench 160 between step S132 and step S133 can utilize step S133 to remove the damage caused by the laser, specifically, step S133 removes the damage caused by the laser while removing the initial tunneling layer and the initial second doped layer.

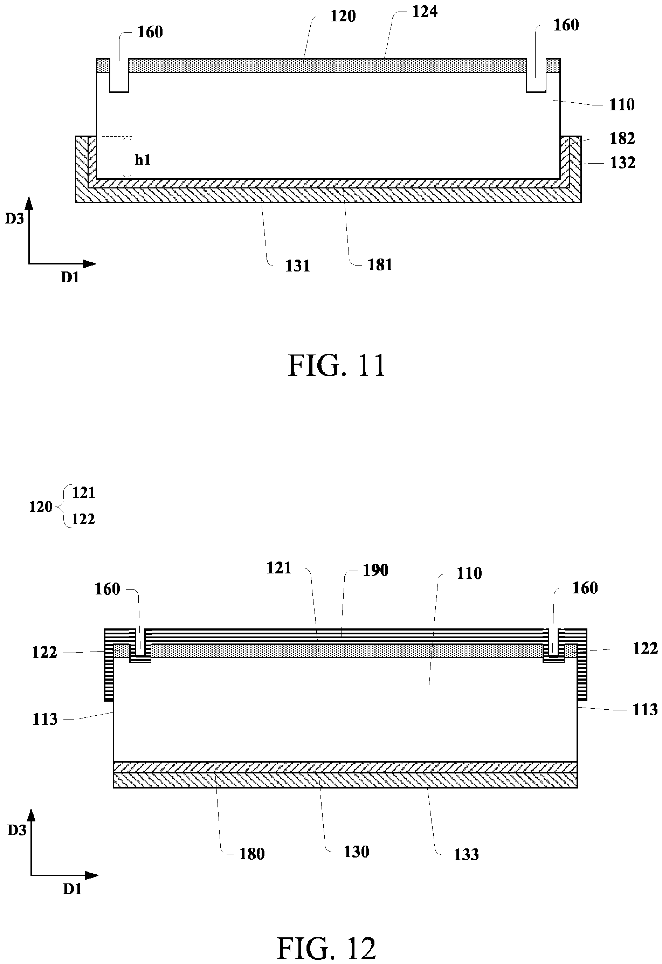

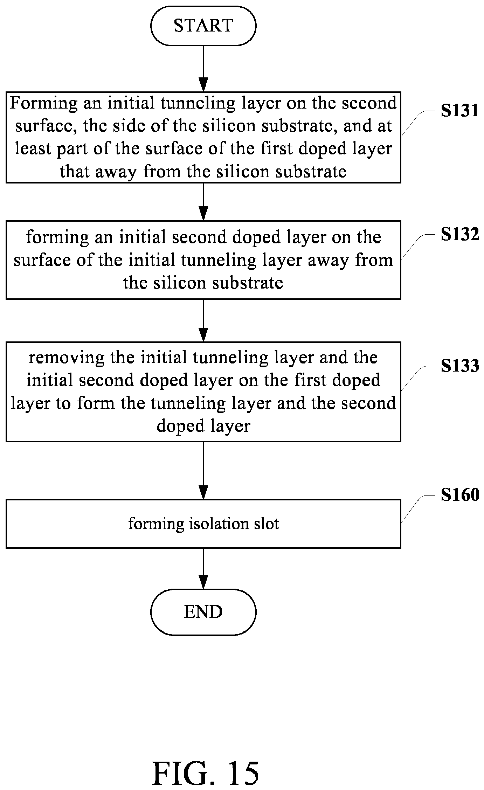

Referring to the schematic flow chart shown in Fig. 15, in other embodiments, the isolation trench 160 may be formed (i.e. step S160) after the removal of the initial tunneling layer and the initial second doped layer on the first doped layer 120 (ie, step S133). Fig. 11 shows the isolation trench formed using the steps in Fig. 15. Comparing with Fig.11 and Fig.10, it can be found that since Fig.15 has removed the initial tunneling layer and the initial tunneling layer on the first doped layer 120 before step S160, therefore, the isolation trench 160 in Fig.11 does not penetrate the initial tunneling layer and the initial second doped layer.

Referring to Fig. 5, Fig. 6, and Fig. 7, in the step of removing the initial first doped layer 120a to form the first doped layer 120, ideally only the initial doped layer located on the first surface 111 should be retained. However, due to factors such as process, the initial first doped layer may remain on other surfaces. For example, the initial first doped layer may remain on side 113 and/or second surface 112. Combined with Fig. 9, these remaining initial first doped layers may connect the first doped layer 120 and the second doped layer 130, as a result, a short circuit occurs between the first doped layer 120 and the second doped layer 130, which may cause the efficiency of the solar cell to decrease.

Referring to Fig.1 and Fig.2, the isolation trench 160 penetrates the first doped layer 120 in the thickness direction D3, and the isolation trench 160 is a closed rectangle, and the closed rectangle surrounds the entire first electrode 140. The first doped layer 120 is divided into two parts by the isolation trench 160, one part is surrounded by the isolation trench 160 (this part is marked as the internal doped layer 121), and the other part is not surrounded by the isolation trench 160 and is located at the edge 170 of the solar cell and the isolation trench 160 (this part is marked as peripheral doped layer 122). The internal doped layer 121 is in contact with the first electrode 140, and carriers (for example, holes or electrons) in the internal doped layer 121 can be transported to the outside of the solar cell through the first electrode 140. Due to the division of the isolation trench 160, the internal doped layer 121 does not contact the peripheral doped layer 122, and there is no electrical connection between the internal doped layer 121 and the peripheral doped layer 122. Therefore, even if the remaining initial first doped layer 120a connects the first doped layer 120 and the second doped layer 130, due to the isolation trench 160, the internal doped layer 121 connected to the first electrode 140 does not contact the second doped layer 130, which avoids a short circuit between the first doped layer 120 and the second doped layer 130, more precisely, avoiding a short circuit occurs between the internal doped layer 121 and the second doped layer 130.

Referring to Fig. 1, the distance between the isolation trench 160 and the edge 123 of the first doped layer 120 is less than a preset distance, wherein the preset distance is any value from 10µm~2000µm. As mentioned above, due to the isolation effect of the isolation trench 160, when the solar cell is operating, the internal doped layer 121 participates in the output of electric energy, and the peripheral doped layer 122 does not participate in the output of electric energy. To increase the electric energy generated by the solar cell, the area of the internal doped layer 121 should be increased as much as possible. Limiting the distance between the isolation trench 160 and the edge of the first doped layer 120 to be less than a preset distance helps to increase the area of the internal doped layer 121, thereby increasing the area of the solar cell that can be used for power generation.

Referring to Fig. 11 and Fig. 12, the surface 124 of the first doped layer 120 is away from the silicon substrate 110 in the thickness direction D3, the first passivation layer 190 is formed on the surface 124, and a first passivation layer 190 is also formed on the side 113 of the silicon substrate 110. The first passivation layer 190 also covers the bottom and sides of the isolation trench 160. The first passivation layer 190 covers the bottom and the sides of the isolation trench 160 due to the first passivation layer 190 was formed after the formation of the isolation trench 160, which makes the first passivation layer 190 connect to the silicon substrate 110 and the first doped layer 120 exposed by the isolation trench 160. In this way, the first passivation layer 190 can achieve good passivation of the isolation trench 160. In other embodiments, the first passivation layer 190 may also be formed only on the surface 124.

In one embodiment, the isolation trench 160 may also be formed after the formation of the first passivation layer 190. Fig. 3 shows a solar cell produced using the above steps, the isolation trench 160 successively penetrates the first passivation layer 190 and the first doped layer 120. Since the isolation trench 160 is formed after the formation of the first passivation layer 190, the first passivation layer 190 does not cover the bottom and the sides of the isolation trench 160. For other descriptions of the first passivation layer 190, please refer to the above and will not be elaborated here.

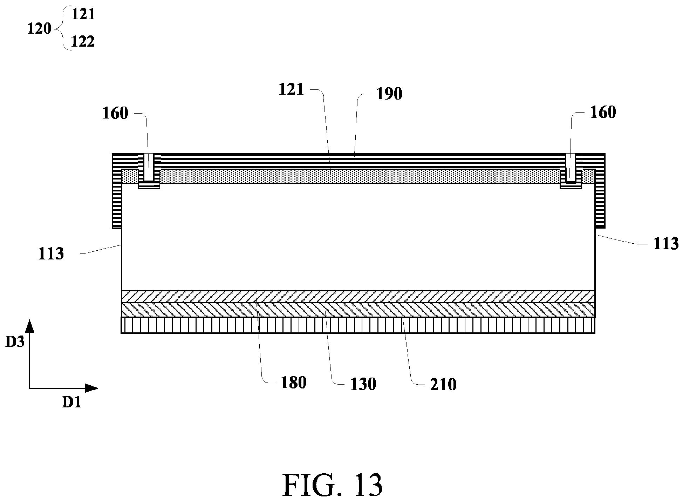

Referring to Fig. 12 and Fig. 13, in one embodiment, the surface 133 of the second doped layer 130 is away from the silicon substrate 110 in the thickness direction D3, and the second passivation layer 210 is formed on the surface 133. In some embodiments, the isolation trench 160 may also be formed after the formation of the second passivation layer 210. In other embodiments, the first electrode 140 and the second electrode 150 are formed after the formation of the second passivation layer 210, and then forming the isolation trench 160.

The basic concepts have been described above, obviously, for those skilled in the art, the above disclosure of the invention is only an example and does not constitute a limitation to the present disclosure. Although not expressly stated here, various modifications, improvements, and amendments to this application may be made by those skilled in the art. Such modifications, improvements, and amendments are suggested in this application, so such modifications, improvements, and amendments still belong to the spirit and scope of the exemplary embodiments of this application.

Meanwhile, the present disclosure uses specific words to describe the embodiments of the present disclosure. For example, "one embodiment", "an embodiment", and/or "some embodiments" refer to a certain feature, structure or characteristic related to at least one embodiment of the present disclosure. Therefore, it should be emphasized and noted that two or more references to "one embodiment" or "an embodiment" or "an alternative embodiment" in different places in this specification do not necessarily refer to the same embodiment. In addition, certain features, structures or characteristics of one or more embodiments of the present disclosure may be properly combined.

In some embodiments, numbers describing the quantity of components and attributes are used, it should be understood that such numbers used in the description of the embodiments use the modifiers "about", "approximately" or "substantially" in some examples. Unless otherwise stated, "about", "approximately" or "substantially" indicates that the stated figure allows for a variation of ±20%. Accordingly, in some embodiments, the numerical parameters used in the specification and claims are approximations that can vary depending upon the desired characteristics of individual embodiments. In some embodiments, numerical parameters should take into account the specified significant digits and adopt the general digit reservation method. Although the numerical ranges and parameters used in some embodiments of the present disclosure to confirm the breadth of the scope are approximate values, in specific embodiments, such numerical values are set as precisely as practicable.

## Claims

1. A solar cell, **characterized by** comprising:
a silicon substrate including a first surface and a second surface opposite to each other;
a first doped layer disposed on the first surface;
a second doped layer disposed on the second surface, wherein a doped type of the first doped layer is opposite to a doped type of the second doped layer;
a first electrode connecting to the first doped layer;
a second electrode connecting to the second doped layer; and
an isolation trench penetrating the first doped layer along a thickness direction of the silicon substrate and surrounding the first electrode.

2. The solar cell according to claim 1, **characterized in that**, a distance between the isolation trench and an edge of the first doped layer is less than a preset distance, wherein the preset distance is 10µm~2000µm.

3. The solar cell according to claim 1, **characterized by** further comprising a tunneling layer, the tunneling layer is disposed on the second surface, and the second doped layer is disposed on a surface of the tunneling layer that away from the silicon sub strate.

4. The solar cell according to claim 3, **characterized in that**, the tunneling layer extends to a side of the silicon substrate and covers at least part of the side of the silicon substrate, and the second doped layer covers the surface of the tunneling layer away from the silicon substrate, wherein a height of the tunneling layer on the side of the silicon substrate is equal to or greater than 0.1µm, and is equal to or less than a thickness of the silicon substrate.

5. The solar cell according to claim 1, **characterized by** further comprising a first passivation layer, the first passivation layer is disposed on a surface of the first doped layer that away from the silicon substrate.

6. The solar cell according to claim 5, **characterized in that**, the first passivation layer covers a bottom and a side of the isolation trench.

7. The solar cell according to claim 1, **characterized by** further comprising a second passivation layer, the second passivation layer is disposed on a surface of the second doped layer that away from the silicon substrate.

8. A method for producing a solar cell, **characterized by** comprising:
providing a silicon substrate including a first surface and a second surface opposite to each other;
forming a first doped layer on the first surface of the silicon substrate;
successively forming a tunneling layer and a second doped layer on the second surface of the silicon substrate, wherein a doped type of the first doped layer is opposite to a doped type of the second doped layer;
forming a first electrode connected to the first doped layer;
forming a second electrode connected to the second doped layer; and
forming an isolation trench penetrating the first doped layer along a thickness direction of the silicon substrate and surrounding the first electrode.

9. The method according to claim 8, **characterized in that**, the method of forming the tunneling layer and the second doped layer comprises:
forming an initial tunneling layer on the second surface, the side of the silicon substrate, and at least part of a surface of the first doped layer that away from the silicon substrate;
forming an initial second doped layer on a surface of the initial tunneling layer away from the silicon substrate;
removing the initial tunneling layer and the initial second doped layer on the first doped layer to form the tunneling layer and the second doped layer.

10. The method according to claim 9, **characterized in that**, after the formation of the initial tunneling layer and the initial second doped layer, and before the removal of the initial tunneling layer and the initial second doped layer on the first doped layer, forming the isolation trench.

11. The method according to claim 9, **characterized by** removing part of the initial tunneling layer and the initial second doped layer on the side of the silicon substrate, a height of the tunneling layer and the second doped layer on the side of the silicon substrate is equal to or greater than 0.1µm, and equal to or less than a thickness of the silicon substrate.

12. The method according to claim 8, **characterized in that**, a distance between the isolation trench and an edge of the first doped layer is less than a preset distance, wherein the preset distance is 10µm~2000µm.

13. The method according to claim 8, **characterized by** forming a first passivation layer on a surface of the first doped layer that away from the silicon substrate.

14. The method according to claim 13, **characterized in that**, the first passivation layer is formed after the formation of the isolation trench.

15. The method according to claim 8, **characterized by** forming a second passivation layer on a surface of the second doped layer that away from the silicon substrate.

16. The method according to claim 15, **characterized in that**, the isolation trench is formed after the formation of the second passivation layer.
